# EUROPEAN PATENT APPLICATION

(11) **EP 2 887 387 A1**
(43) Date of publication of application: **24.06.2015**
(21) Application number: 13199196.0
(22) Date of filing: 20.12.2013
(51) Int. Cl.: H01L 21/84, H01L 21/762, H01L 27/12, H01L 29/732, H01L 29/739, H01L 29/78

(54) **Semiconductor device and associated method**

(71) Applicant: NXP B.V., 5656 AG Eindhoven (NL)
(72) Inventor: in 't Zandt,, Michael Antoine Armand, Redhill, Surrey RH1 1SH (GB); Steeneken,, Peter Gerard, Redhill, Surrey RH1 1SH (GB)
(74) Representative: Miles, John Richard

(57) **Abstract**

The invention relates to a semiconductor device and an associated method for fabricating the semiconductor device. The device comprises: a substrate having a contact surface and a back surface separated by a total distance; a vertical device formed in the substrate and having first and second terminals on the contact surface; an isolation trench extending the total distance through the substrate between the contact surface and the back surface to electrically isolate the vertical device; and a terminal separation trench extending from the contact surface into the substrate and arranged to separate and define an electrical conduction path between the first and second terminals of the vertical device.

## Description

The invention relates to a semiconductor device and an associated method for preparing the semiconductor device. In particular, although not exclusively, the invention relates to a semiconductor device comprising a vertical device with a top side contact separated from a complementary metal-oxide-semiconductor transistor by an isolating trench.

Many products require multiple CMOS circuits and power devices that operate at different voltages. Sometimes, the voltage difference between these multiple circuits can be quite large. Accordingly, to prevent damage to electronic circuits or to prevent unsafe operation of electronic circuits, high voltage isolation may be required. Circuits manufactured using standard CMOS processing may not offer high voltage isolation, so if substantial isolation is required, then special processes may be required that incorporate isolation using silicon on insulator (SOI) substrates or by growing dedicated buried epitaxial layers for junction isolation. The cost per wafer area of these processes and substrates is high, the area taken by the isolation regions is large, and these processes may require long development times. For this reason they are usually not available until long after the state of the art of CMOS manufacturing has advanced. For example, this may lead to high voltage CMOS transistor circuits that are manufactured using manufacturing processes that are 5-10 years behind the current state of the art CMOS processing techniques.

One of the disadvantages of some prior art CMOS/power device integration processes is that lateral devices such as laterally diffused metal oxide semiconductor (LDMOS) transistors and junction field effect transistors (JFETs) are used and, depending on the breakdown voltage (BV) of these devices, they typically require a relatively large silicon area.

In the separate field of discrete components, many varieties of vertical devices, that is, a semiconductor device with a vertical structure, are known and used. Both transistors and diodes, for example, can be implemented as discrete vertical devices. In a conventional vertical transistor, drain-source current flow occurs substantially normal to the contact and back surface planes of a substrate of the device, as opposed to parallel with the substrate as in a lateral transistor.

Vertical transistors have an advantage in comparison with lateral transistors, such as those provided on SOI and junction isolated wafers, since they have a lower specific on-resistance. For example, vertical double diffused metal oxide semiconductor (VDMOS) transistors can offer an intrinsically lower on-resistance at breakdown due to the more efficient use of the vertical dimension of the silicon. Even lower specific on-resistance is possible by using trench metal oxide semiconductor (TrenchMOS, also known as UMOS) transistors which eliminate the resistance of the JFET region in the VDMOS. Vertical devices are therefore often used as discrete power devices.

A disadvantage of vertical devices in comparison with lateral devices is that connections to a lateral device are required on both sides of its substrate. As such, package design and manufacture can be substantially more difficult and therefore costly. Furthermore, substantial difficulty would be experienced in integrating a vertical transistor with prior art SOI and junction isolated wafers.

According to a first aspect of the invention there is provided a semiconductor device comprising:
a substrate having a contact surface and a back surface separated by a total distance;
a vertical device formed in the substrate and having first and second terminals on the contact surface;
an isolation trench extending the total distance through the substrate between the contact surface and the back surface to electrically isolate the vertical device; and
a terminal separation trench extending from the contact surface into the substrate and arranged to separate, and define an electrical conduction path between, the first and second terminals of the vertical device.

The invention combines the advantages of a vertical device with a simplicity of handling typically only found in lateral devices. That is, the full substrate thickness can be used for lateral conduction of current which provides a lower on resistance. However, the second terminal, which would typically be provided on the back surface of a vertical device, is brought to the contact surface via the electrical conduction path defined by the terminal separation trench. Both the first and second terminals are provided on the contact surface, which enables simplified connection to the vertical device.

The provision of the isolation trench enables a high voltage vertical device to be integrated with a low or medium voltage device on a single wafer. Cheaper substrate materials can be used because it is not essential for the semiconductor device to be fabricated on a silicon-on-insulator wafer.

The semiconductor device may include a second device on an opposing side of the isolation trench to the vertical device. The second device may comprise a lateral transistor or a vertical transistor. The lateral transistor may be a LDMOS transistor or JFET. The second device may be a CMOS device. The isolation trench may electrically isolate the vertical device from the second device.

The isolation trench may be a first isolation trench. The semiconductor device may comprise a second isolation trench. The second isolation trench may extend the total distance through the substrate between the contact surface and the back surface to electrically isolate the vertical device. The first and second isolation trenches may be provided on opposing sides of the vertical device. Alternatively, the isolation trench may be continuous and may be provided on opposing sides of the vertical device. Such an isolation trench can be considered to form a silicon island. The vertical device may be provided on the silicon island. Any sides/edges of the vertical device which are not bounded by an isolation trench may need an edge termination for handling high voltage. This edge termination may consume an area of the substrate. It is therefore in many cases advantageous to create such a silicon island.

The vertical device may comprise a vertical transistor or vertical diode. The vertical transistor may be a VDMOS or TrenchMOS transistor. The vertical transistor may comprise a gate terminal. The first terminal may be a source terminal. The second terminal may be a drain terminal. Alternatively, the first and second terminals may each provide one of an anode and a cathode of the vertical diode.

An electrically insulating and thermally conductive material, such as aluminium nitride or oxide, may be provided on the back surface. The electrically insulating and thermally conductive material may enable semiconductor devices to be stacked with each other. That is, the electrically insulating and thermally conductive material may allow heat to be removed from the semiconductor device more easily when, for example, the back surface of the substrate is glued or soldered to a heat sink.

The isolation trench and/or terminal separation trench may comprise a dielectric material.

The electrical conduction path may be at least partially defined by a metallic material provided within the substrate. The metallic material may be a metal or alloy. The electrical conduction path may be at least partially defined by a doped region of the substrate.

According to a second aspect of the invention there is provided a method of fabricating a semiconductor device, comprising:
receiving a substrate having a contact surface with a vertical device formed in the substrate and having a first terminal on the contact surface;
forming an isolation trench extending a first distance through the substrate for electrically isolating the Vertical device; and
forming a terminal separation trench extending from the contact surface into the substrate, the terminal separation trench arranged to define a second terminal of the vertical device on the contact surface and to define an electrical conduction path between first and second terminals.

The isolation trench may be a first isolation trench. The method may comprise forming a second isolation trench on an opposing side of the vertical device to the first isolation trench. The second isolation trench may be configured to electrically isolate the transistor.

The substrate may have a back surface separated by a total distance from the contact surface. Forming the isolation trench may comprise removing substrate material from the back surface. Forming the isolation trench may comprise removing substrate material from the contact surface. The substrate material may be removed from the contact surface subsequent to removing substrate material from the back surface.

The method may comprise reducing a thickness of the substrate from an initial thickness to a final product thickness to form a back surface opposing the contact surface. The isolation trench and terminal separation trench may be formed during the same processing step.

The method may comprise providing an electrically insulating and thermally conductive material on the back surface.

The method may comprise providing a support structure on the connection surface. The first distance may be a total distance between the connection surface and the back surface.

The method may further comprise providing a mask layer on the contact surface to define the terminal separation trench or the isolation trench. The method may further comprise providing a mask layer on the back surface to define the isolation trench.

The method may further comprise filling the isolation trench and/or terminal separation trench with a dielectric material.

The received substrate may further have an oxide plug formed adjacent to the first terminal for providing a second contact. The method may further comprise providing a mask layer on the back surface that exposes at least part of an island of substrate that comprises the vertical device. The method may further comprise etching away the substrate of the vertical device from the back surface. The method may further comprise etching away the oxide plug from the back surface to provide a void. The method may further comprise filling the void with a metallic material. The method may further comprise providing a layer of metallic material over the etched away back surface of the vertical device. The metallic material within the void and the metallic layer may provide a metallic, electrical conduction path.

One or more embodiments of the invention will now be described, by way of example only, and with reference to the accompanying figures in which:
Figure 1 a illustrates a method of fabricating a semiconductor device;
Figure 1b illustrates a substrate received by the method of figure 1a;
Figure 1c illustrates the semiconductor device fabricated by the method of figure 1 a;
Figure 2a illustrates a scanning electron micrograph of a series of trenches prepared using a deep reactive ion etching method;
Figure 2b illustrates a schematic cross-section of an integrated TrenchMOS device in CMOS after etching of isolation trenches;
Figure 3 illustrates a schematic cross-section of the semiconductor device of figure 2b after polymer trench filling;
Figure 4 illustrates a schematic cross-section of the semiconductor device of figure 3 after contact window etching and metal redistribution layer deposition and structuring;
Figure 5 illustrates a schematic cross-section of the semiconductor device of figure 4 after wafer grinding and application of a backside isolation layer;
Figure 6 illustrates a schematic cross-section of the semiconductor device of figure 3 after a blanket etch-back or chemical mechanical polishing of the polymer, contact window etching and metal redistribution layer deposition and structuring, wafer grinding and application of a backside isolation layer;
Figure 7a illustrates a plan view of a possible layout of a semiconductor device;
Figure 7b illustrates a plan view of a second possible layout of a semiconductor device;
Figure 7c illustrates a plan view of a third possible layout of a semiconductor device;
Figure 8 illustrates a schematic cross-section of a second integrated TrenchMOS device in CMOS after isolation trench etching;
Figure 9 illustrates a schematic cross-section of the semiconductor device of figure 8 after deposition of a polymer layer on the back surface of the substrate;
Figure 10 illustrates a schematic cross-section of the semiconductor device of figure 9 after blanket etching or chemical mechanical polishing of the polymer layer and hard mask and deposition of a backside isolation layer;
Figure 11 illustrates a schematic cross-section of the semiconductor device of figure 9 after opening windows in the polymer layer and hard mask followed by deposition of a backside isolation layer;
Figure 12 illustrates a schematic cross-section of the semiconductor device of figure 11 after deposition of a hard mask on an interconnector layer and trench etch;
Figure 13 illustrates a schematic cross-section of a semiconductor device after an insulating polymer has been deposited in the contact surface trenches and contact forming trench;
Figure 14 illustrates a schematic cross-section of a semiconductor device where the polymer layer of figure 13 was blanket etched-back or chemical mechanical polished before contact window etching and deposition of a metal redistribution layer;
Figure 15 illustrates a schematic cross-section of a semiconductor device where back surface trenches extend throughout the substrate to form isolation trenches;
Figure 16a illustrates a partially fabricated semiconductor device similar to that described with reference to figure 2b with an additional silicon dioxide plug;
Figure 16b illustrates the semiconductor device similar to that described with reference to figure 3;
Figure 16c illustrates the semiconductor device of figure 16b after the substrate has been ground back;
Figure 16d illustrates the semiconductor device of figure 16c after metal contacts on the contact surface have been uncovered and an etch window has been formed on the back surface;
Figure 16e illustrates the semiconductor device of figure 16d after silicon has been etched away from the back surface of the vertical device;
Figure 16f illustrates the semiconductor device of figure 16e after a wet silicon dioxide etching process has been applied to remove the silicon dioxide plug;
Figure 16g illustrates the semiconductor device of figure 16f after a structured metal layer has been formed on the contact surface and the back surface of the vertical transistor; and
Figure 16h illustrates the semiconductor device of figure 16g after an insulating layer of material has been provided on the metal layer at the back surface of the device.

For a growing amount of applications, integrating vertical high voltage and power devices in CMOS has many advantages. This disclosure describes a method to create isolated silicon islands consisting of vertical high voltage devices with silicon areas to connect a back surface contact of the vertical device to the front, contact surface. The separate silicon areas can be made in a single masked step, which is also be referred to as "self-assembly".

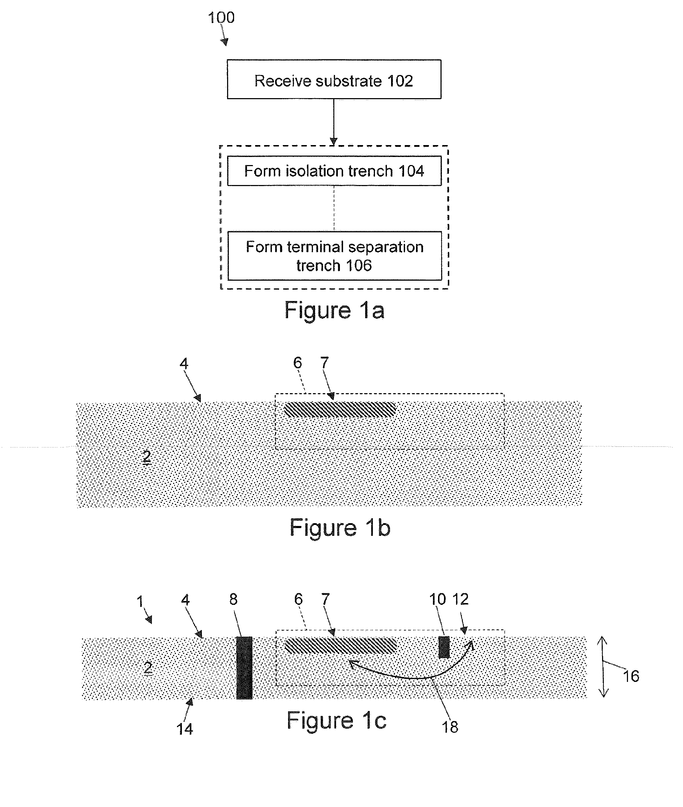

The disclosure relates to semiconductor devices and associated methods for preparing the semiconductor devices. Figure 1 a illustrates a method 100 of fabricating a semiconductor device 1 starting from a feed substrate 2. The feed substrate 2 is shown in figure 1b whereas the fabricated semiconductor device 1 is illustrated in figure 1c.

The method 100 comprises an initial step of receiving 102 the substrate 2. The substrate 2 has a contact surface 4 and a vertical device 6 formed in the substrate 2. The vertical device 6 provides a first terminal 7 on the contact surface 4.

The method 100 comprises forming 104 an isolation trench 8 extending a first distance through the substrate 2 for electrically isolating the vertical device 6. The method 100 also comprises forming 106 a terminal separation trench 10 extending from the contact surface 4 into the substrate 2 and arranged to define a second terminal 12 of the vertical device 6 on the contact surface 4. The step of forming 104 the isolation trench 8 can be performed before, after or simultaneously with the step of forming 106 the terminal separation trench 10. The isolation trench 8 and terminal separation trench 10 may be filled with a polymer insulator to form a dielectric.

In the fabricated device 1, the substrate 2 has a back surface 14 separated by a total distance 16 from the contact surface 4.

The isolation trench 8 extends the total distance 16 through the substrate 2 between the contact surface 4 and the back surface 14 in order to electrically isolate the vertical device 6 from the remainder of the wafer (on an opposing side of the isolation trench 8 to the vertical device 6). The provision of the isolation trench 8 means that the fabricated device 1 contains an isolated silicon island. The island houses the vertical high voltage device 6. A high voltage vertical device 6 can be isolated from a low or medium voltage circuitry CMOS device by the (polymer filled) isolation trench 8 through the substrate 2. Operating voltages of > 1 kV for the vertical device 6 can be achieved on a single CMOS wafer without destroying or damaging the low or medium voltage devices.

The vertical device 6 is formed in the substrate 2 has first and second terminals 7, 12 on the contact surface 4.

The terminal separation trench 10 extends from the contact surface 4 into the substrate 2 and is arranged to separate the first and second terminals 7, 12 of the vertical device 6. That is, the terminal separation trench 10 is provided on the contact surface 4 between the first terminal 7 and the second terminal 12. The terminal separation trench 10 also defines an electrical conduction path 18 between first and second terminals 7, 12.

The terminal separation trench 10 provides 'self-assembling' silicon areas to connect the back surface contacts (N⁺⁺ drain region) of the vertical devices to the contact surface 4 without the use of a conventional through-silicon via (TSV). The terminal separation trench 10 enables the advantages of a vertical device to be provided with a simplicity of handling and contact fabrication typically found in lateral devices. That is, the full substrate thickness of the substrate 1 can be used for lateral conduction of current, which provides a lower on resistance. However, the second terminal 12, which would typically be provided on the back surface 14 of a conventional vertical device, is brought to the contact surface 4 via the electrical conduction path 18 defined by the terminal separation trench 10. As such, both the first and second terminals 7, 12 are provided on the contact surface 4.

The use of the terminal separation trench 10 instead of a conventional TSV means that the method 100 is simplified. A reason for this is that the fabrication of TSVs can be quite complex because of the necessity to fill a high aspect ratio trench with conducting materials as would be required by such a process.

The vertical device 6 may be a vertical transistor, such as a TrenchMOS or VDMOS transistor. In this case, the first terminal 7 may be a source terminal and the second terminal 12 may be a drain terminal. A gate of the vertical transistor may also be provided on the contact surface 4 adjacent to the source terminal.

Alternatively, the vertical device 6 may be a diode, in which case the first terminal 7 and second terminal 12 may each provide one of an anode and a cathode of the diode.

Due to the provision of the isolation trench 8, a second device such as a low voltage CMOS device can be provided on the same substrate 2 as the vertical device 6 and so the semiconductor device 1 can be considered to be an integrated device. In such an example, the isolation trench 8 electrically isolates the vertical device 6 from the second device. Typically, the second device is provided in the substrate 2 received 102 when the method 100 commences.

The semiconductor device 1 may provide various functions, such as integrated HV switch, HV Analogue Mixed Signal (AMS) + a vertical power device, floating/high side device islands. Various advantages of the semiconductor device 1 will be appreciated by the skilled person, such as that less electro-static discharge (ESD) protection may be needed, that electro-magnetic interference or electromagnetic coupling (between the high and low power devices) may be reduced. Additionally, the requirement for optocouplers between high and low voltage systems may be eliminated. Opto-couplers are used to provide electrical isolation by only transferring signals by electromagnetic waves (light) that travel through a transparent dielectric material with a high voltage blocking capability. A more recent alternative to opto-couplers are on-chip capacitive or inductive isolators. In an on-chip capacitive isolator, two plates of a capacitor are separated by a similar dielectric material. High-frequency signals can travel between the plates of the capacitors whereas low-frequency or DC voltages are blocked. In case of inductive isolators, the isolator is made using two dielectrically-separated inductors that form an isolating transformer. Since silicon islands are separated by isolating trenches, the trenches can function as the dielectric in these applications. That is, the isolation trenches can be part of a galvanic isolator. Alternatively, the isolation trenches can block high voltages and the isolation capacitors or inductors may be fabricated on the contact surface 4 of the substrate.

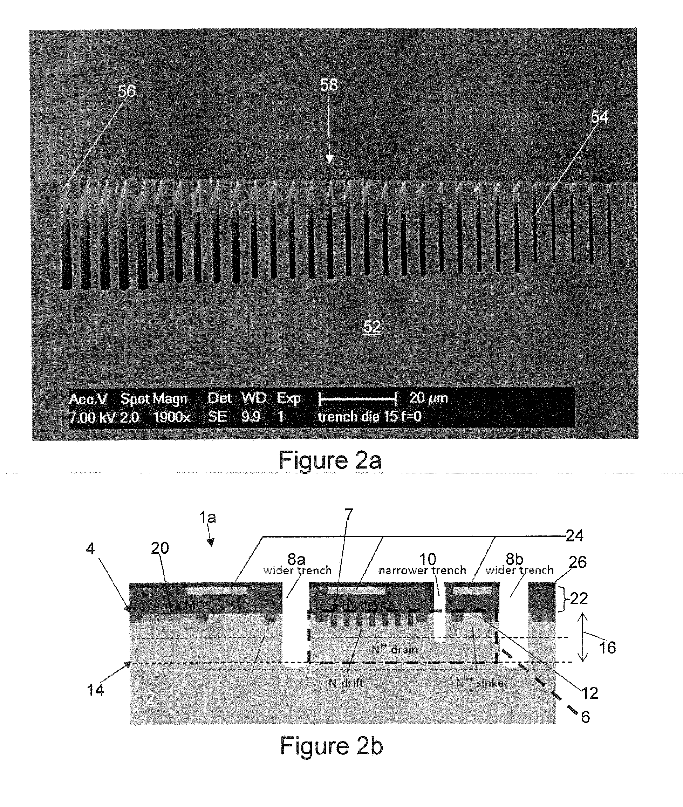

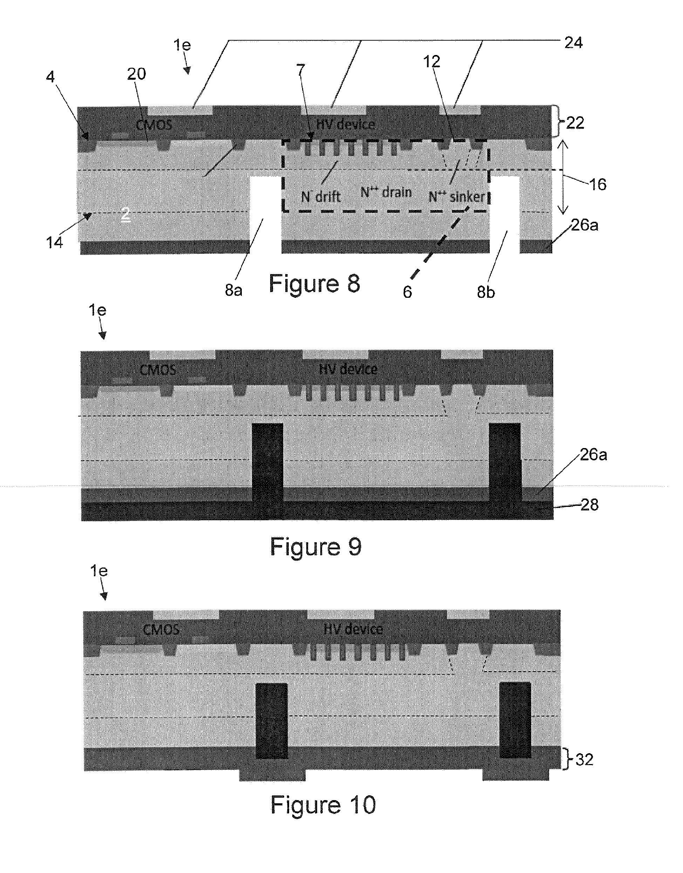

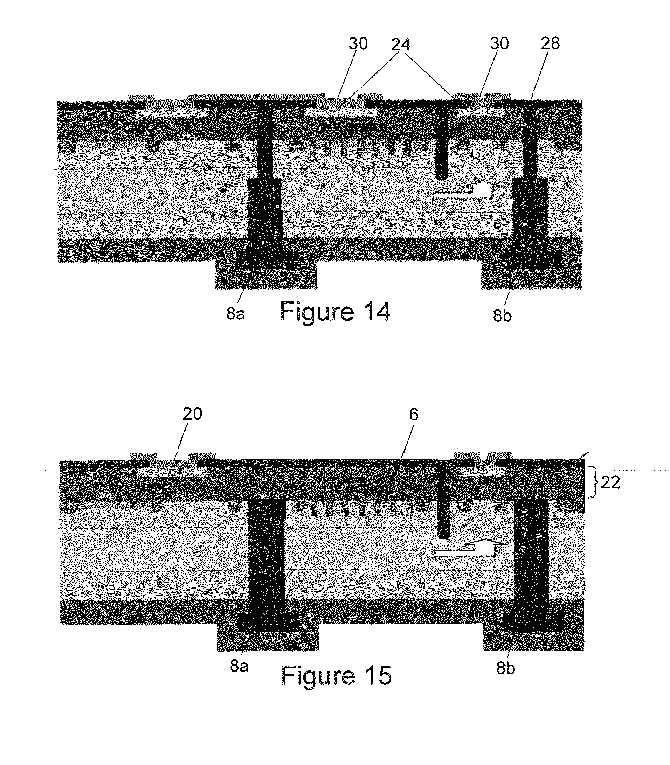

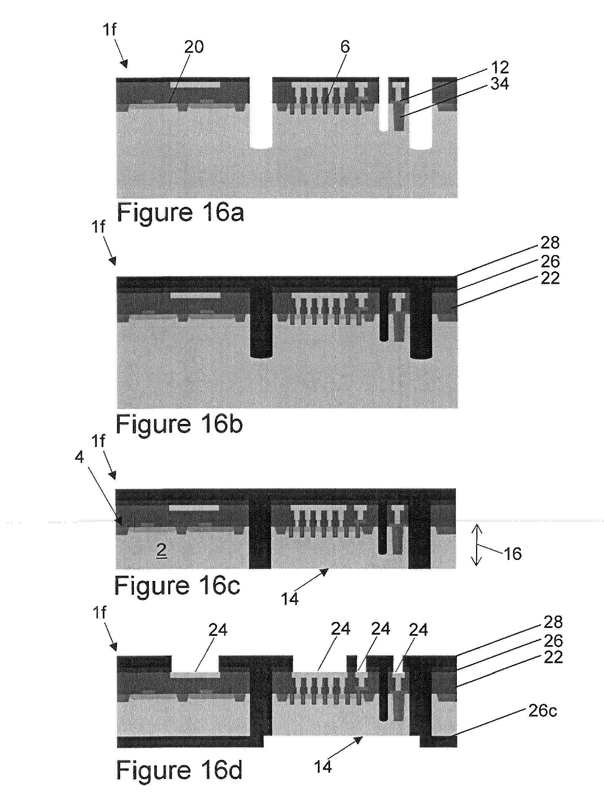

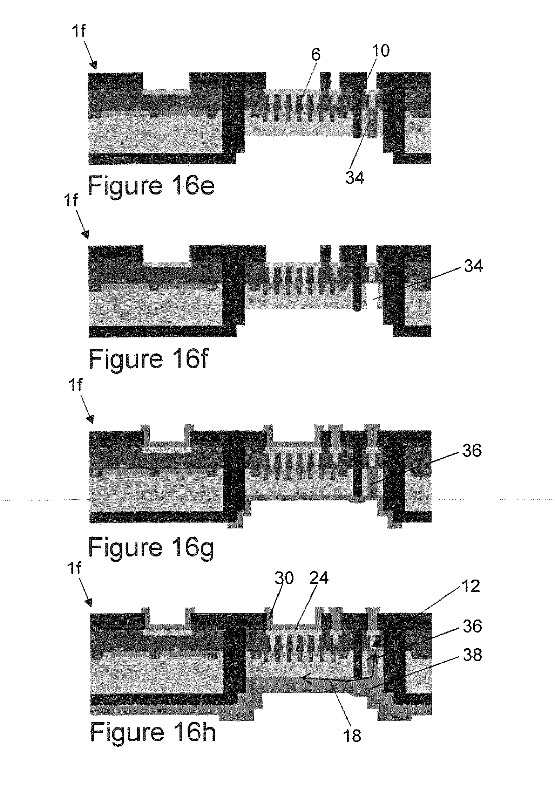

Various optional features and method steps are described below with reference to figures 2b to 16. Specifically, four processing routes for fabricating the semiconductor device are disclosed. Figures 2b to 7 relate to a first processing route, figures 8 to 14 relate to a second processing route, figure 15 relates to a third processing route and figures 16 relates to a fourth processing route. Corresponding reference numerals are used to refer to similar features throughout the figures.

In a dry reactive ion etching (DRIE) process, the etch rate depends on the desired trench width. Trenches of various depths can therefore be provided in a single trench etch step by masking out different trench widths. As a result, it is possible to reduce the number of lithography steps when providing multiple trenches. There is no need for there to be a particular mutual alignment between the various trenches.

Figure 2a illustrates a scanning electron micrograph of a series of trenches 54, 56 in a substrate 52 prepared using the "Bosch" deep reactive ion etching process. The reactive ions that formed the trenches 54, 56 were accelerated incident normal 58 to the surface of the substrate 52 in the plane of the page. The depth of the trenches 54, 56 varies depending on the width of the trench such that a wider trench 56 is deeper than a narrower trench 54. Trench depth differences within the trench etch process can be tuned by accurately varying the trench width because of the etch rate dependence on trench width. This may be advantageously used to form an isolation trench and a terminal separation trench in the same etching step, as will be described below.

Figure 2b illustrates a partially fabricated semiconductor device. Specifically, figure 2b illustrates a schematic cross-section of an integrated semiconductor device 1 a comprising a TrenchMOS device in CMOS after trench etching.

The integrated semiconductor device 1 a has a first isolation trench 8a and a second isolation trench 8b. The first and second isolation trenches 8a, 8b are provided on opposing sides of the vertical device. It will be appreciated that, in practice, the first and second isolation trenches 8a, 8b may be provided by a continuous trench that extends in three dimensions to isolate and/or surround the vertical device.

In order to provide the partially fabricated semiconductor device 1a, the method starts by receiving a processed wafer substrate 2. In this example the substrate 2 further comprises a CMOS device 20. The vertical device 6 is a TrenchMOS high voltage device and comprises, extending into the substrate 2 away from the source region 7 on the contact surface 4, an N⁻ drift region. Below the N⁻ drift region (further towards the back surface 14) is an N⁺⁺ buried drain layer. An N⁺⁺ sinker is provided at a drain contact 12 extending from the contact surface 4 to the N⁺⁺ buried drain layer. The sinker provides a conductive channel in the substrate from the drain contact 12 to the N⁻ drift region. The N⁺⁺ buried layer may be epitaxially grown on a low doped silicon substrate, or alternatively, an N⁺⁺ substrate may be used.

An interconnector layer 22 is provided on the contact surface 4 of the substrate 2. Various contacts 24 are provided within the interconnector layer 22 for connecting the CMOS and TrenchMOS devices 20, 6.

A hard mask 26 is deposited on the interconnector layer 22 using plasma enhanced chemical vapour deposition PECVD silicon dioxide, for example. After photolithography, trench windows are provided on the interconnector layer 22. The hard mask 26 around the windows protects the interconnect layer 22 during etching. Then trenches 8, 10 may be etched using the deep reactive ion etching (Bosch) process, for example. As described with reference to figure 2a, the trench width may be varied to alter the trench depth.

The first and second isolation trenches 8a, 8b are provided by wider trenches that have a depth that reaches at least through the total thickness 16 of the substrate 2 after a subsequent grinding step. The first and second isolation trenches 8a, 8b are therefore typically greater than 100 µm deep and can have a width of 20 to 100 µm. In this way, the first isolation trench 8a can be used to electrically isolate the CMOS device from the vertical device 6. A second CMOS device 20 could be provided on the substrate 2 electrically isolated from the vertical device 6 by the second isolation trench 8b.

The terminal separation trench 10 is provided by a narrower trench that has a depth that reaches at least the highly N⁺⁺ doped drain region of the vertical HV device 6, but not through the full thickness 16 of the substrate 2. This is important to achieve sufficient isolation between the drain contact and the rest of the HV device and for this to be achieved the terminal separation trench 10 must extend so that the N⁻ drift region is cut off from the sinker. Otherwise, electrical breakdown between the N⁻ drift region and the sinker may occur. The terminal separation trench 10 is typically greater than 10 µm deep. However, the required depth of the terminal separation trench 10 depends on the desired breakdown voltage for the application. The depth of the terminal separation trench in microns should be more than the breakdown voltage in volts of the vertical device divided by 30. For example, a 10 um deep trench may have a breakdown voltage of less than 300 V, in practice it may handle about 60 V.

The duration of a single etch step that forms a plurality of trenches is substantially less than the duration of a plurality of etch steps to form the trenches individually. Providing the terminal separation trench 10 and the isolation trench 8 or trenches 8a, 8b in a single trench etching is advantageous because the trench etching step is one of the costliest steps in the fabrication process due to its relatively long duration.

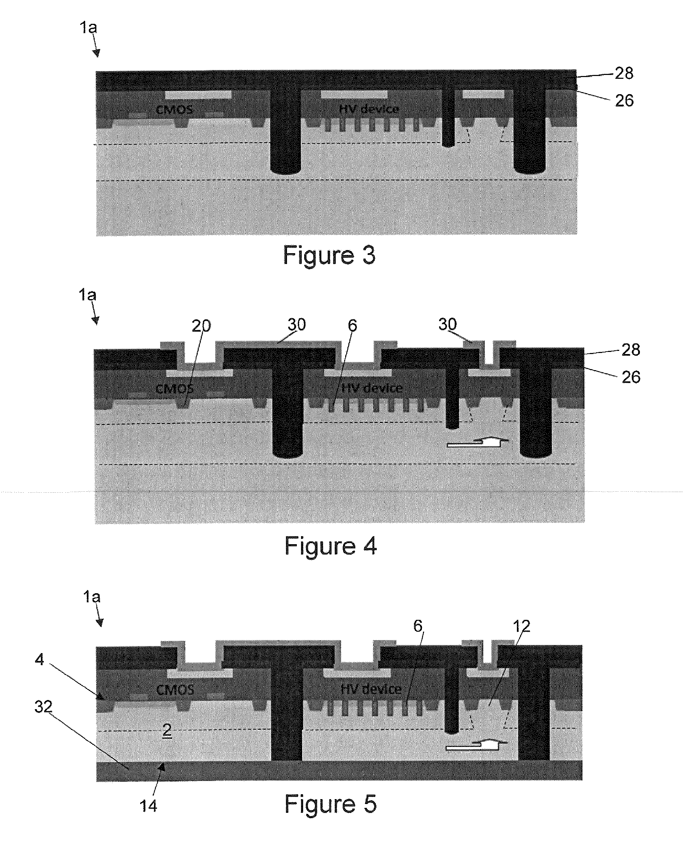

Figure 3 illustrates a schematic cross-section of the semiconductor device 1 a of figure 2b after polymer trench filling. The trenches 8a, 8b, 10 are filled with a dielectric material such as a polymer, benzocyclobutene (BCB), polyimide or Parylene, for example. In order to ensure good trench filling, reflow and/or curing of the polymers may be necessary. A polymer layer 28 is also disposed on the hard mask layer 26.

The trench width together with the electrical strength of the filling polymer determine the maximum isolation voltage that can be sustained across a trench. For example, a 2 µm wide trench filled with a polymer (such as BCB) with an electrical strength greater than 500 V/µm can be used to isolate areas with a potential difference of greater than 1 kV.

Figure 4 illustrates a schematic cross-section of the semiconductor device 1a of figure 3 after contact window etching and metal redistribution layer deposition and structuring. The contact windows in the polymer layer 28 and the hard mask 26 are etched in order to create electrical connections between the CMOS 20 and the HV device island. Where the polymer layer 28 is photo sensitive, exposure and developing of the polymer may be used as an alternative to etching.

A metal redistribution layer 30 is deposited (e.g. seed layer depositing and plating) and structured after the windows in the polymer layer 28 and the hard mask 26 have been formed. For example, the drain of a CMOS transistor 20 is connected to the gate of the vertical transistor 6 by the metal redistribution layer 30. A drain terminal for the vertical transistor 6 is provided on the top side of the structure by the metal redistribution layer 30. The metal redistribution layer 30 also provides connections for the source connection of the vertical transistor 6 which is out of plane of the cross-section in Figure 4.

Figure 5 illustrates a schematic cross-section of the semiconductor device of figure 4 after wafer grinding and the application of a backside isolation deposition layer 32.

The wafer grinding reduces the thickness of the substrate such that the dielectric filled isolation trenches 8a, 8b pass through the substrate 2 from the contact surface 4 to the back surface 14. If necessary, an additional etch back of the substrate 2 after grinding can be performed to reduce or eliminate leakage currents along the bottom of the wider isolation trenches 8a, 8b. Subsequently, backside coating is performed to fully isolate the silicon islands from each other and to make it possible to put the semiconductor device 1 a on a lead frame for packaging or stacked on another device.

The backside isolation deposition layer 32 provides a stack of layers configured to electrically isolate the vertical device 6 from the exterior at the back surface 14. Preferably, the backside isolation layer 32 should be a good thermal conductor to transport the heat generated in the HV device to the outside of the chip. The backside isolation layer 32 can, for example, be deposited with physical vapour deposition (PVD), spin coating, evaporation or plasma enhanced chemical vapour deposition (PECVD).

Aluminium nitride (AlN) and aluminium oxide (Al₂O₃) are examples of materials that offer both suitably high electrical strength and high thermal conductivity to be used as the backside isolation deposition layer 32. An intermediate layer may be provided to avoid adhesion issues between AlN and the substrate 2. Thin layers (e.g. nanometre thickness) of electrically isolating materials can be used as the intermediate layer. Such thin layers do not significantly impede heat transport.

The backside isolation technique, that is, providing an electrically insulating and thermally conductive material on the back surface 14, may also be applicable to other semiconductor device technologies where high thermal conductivity to the outside of the chip is important.

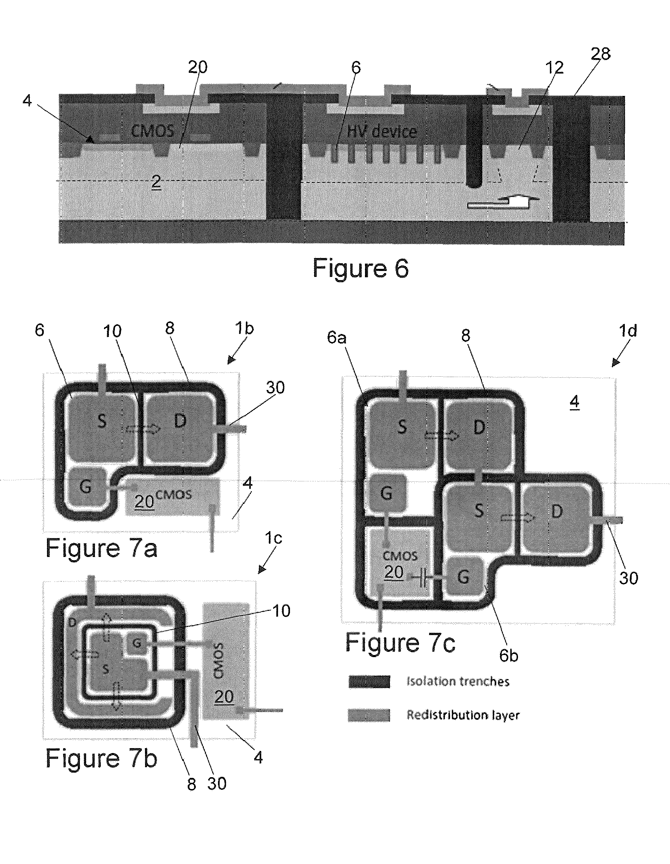

An alternative process route is to perform a blanket etch back or chemical mechanical polishing step of the polymer layer 28 as shown in Figure 6.

The semiconductor device structures shown in figures 5 and 6 both provide a fully isolated vertical HV device 6 integrated with a CMOS device 20 with a drain contact 12 to the front, contact side 4 of the substrate 2. The drain contact 12 is formed in-situ by making use of trench depth differences as a result of etch rate differences depending on the trench width.

Figure 7a, 7b and 7c illustrate schematic plan views of three possible layouts of the semiconductor device 1b, 1c, 1d as seen at the contact surface 4. In each semiconductor device 1b, 1 c, 1 d, a vertical transistor 6, 6a, 6b is provided on an island with source (S), drain (D) and gate (G) connections fully surrounded by a through-wafer isolation trench 8. Also, in each semiconductor device 1b, 1 c, 1 d, a narrower, shallower terminal separation trench 10 is provided between respective source (S) and drain (D) connections of the respective vertical transistors 6. A redistribution layer 30 connects the vertical transistor device 6 to other areas of the substrate 2.

In figure 7a, the semiconductor device 1b comprises an island occupied by a vertical transistor 6 and surrounded by a continuous isolation trench 8. The vertical transistor 6 has a source region (S) and a drain region (D) separated by a terminal separation trench 10. A gate region (G) of the vertical transistor 6 is provided adjacent to the source region (S). A CMOS circuit 20 is provided on an opposing side of the continuous isolation trench 8 to the vertical transistor 6. A redistribution layer 30 connects the source region (S) and drain region (D) to the remainder of the wafer and the gate (G) to the CMOS circuit 20.

In figure 7b, the semiconductor device 1c comprises an island occupied by a vertical transistor 6 and surrounded by a continuous isolation trench 8. The vertical transistor 6 has a source region (S) and a drain region (D) separated by a continuous terminal separation trench 10. That is, the source (S) is provided within the continuous terminal separation trench 10 and the drain is provided on an opposing, outer side of the continuous terminal separation trench 10. The drain region (D) extends around the continuous terminal separation trench 10. A gate region (G) of the vertical transistor is provided adjacent to the source region (S) within the continuous terminal separation trench 10. A CMOS circuit 20 is provided on an opposing side of the continuous isolation trench to the vertical transistor 6. The drain region (D) is discontinuous (does not entirely surround the source region (S)) so that a redistribution layer 30 can connect the source region (S) to the remainder of the wafer and the gate (G) to the CMOS circuit 20. The redistribution layer 30 also connects the drain region (D) to the remainder of the wafer.

In figure 7c, the semiconductor device 1d comprises a first vertical transistor 6a and a second vertical transistor 6b. Each of the vertical transistors 6a, 6b has a similar construction to that of the semiconductor device 1b in figure 7a. The vertical transistors 6a, 6b occupy different islands separated by an isolation trench 8.

A CMOS circuit 20 is also provided on a separate island from each of the vertical transistors 6a, 6b by the isolation trench 8.

A redistribution layer 30 connects:
the source region (S) of the first vertical transistor 6a to the remainder of the wafer;
the source region (S) of the second vertical transistor 6b to the drain region (D) of the first vertical transistor 6a;
the drain region (D) of the second vertical transistor 6b to the remainder of the wafer; and
the gate (G) of the first transistor 6a to the CMOS circuit 20.

The gate (G) of the second transistor 6b is capacitively coupled to the CMOS circuit 20. By "capacitively coupled" it is meant that a signal from the CMOS circuit is transferred through a galvanic isolator to drive the gate of the transistor. This can be a capacitive isolator, with additional gate driving circuitry, for example.

In general, a semiconductor device may provide a plurality of vertical devices separated by an isolation trench or trenches.

Figures 8 to 14 relate to an alternative processing route to that described with reference to figures 2b to 7. In this process route, the isolation trenches 8 are formed in a two-step process. That is, forming the isolation trenches 8 comprises removing substrate material from the back surface 14 and subsequently removing substrate material from the contact surface 4.

Figure 8 illustrates a partially fabricated semiconductor device 1e. As in the previous process, the method starts by receiving a processed wafer substrate 2. The substrate 2 comprises a CMOS device 20. The vertical device 6 is a TrenchMOS high voltage vertical device 6 and comprises, extending into the substrate 2 away from the source region 7 on the contact surface 4, an N⁻ drift region. Below the N⁻ drift region (further towards the back surface 14) is an N⁺⁺ buried drain layer. An N⁺⁺ sinker is provided at a drain contact 12 extending from the contact surface 4 to the N⁺⁺ buried drain layer. A sinker provides a conductive channel in the substrate from the drain contact 12 to the N⁻ drift region. The N⁺⁺ buried layer may be epitaxially grown on a low doped silicon substrate, or alternatively, an N⁺⁺ substrate may be used.

As in figures 2b to 7, the semiconductor device 1e comprises an interconnector layer 22 provided on the contact surface 4 of the substrate 2. Various contacts 24 are provided within the interconnector layer 22 for connecting the CMOS and TrenchMOS devices 20, 6 to external circuitry.

The semiconductor device 1 e has a hard mask 26a deposited on the back surface 14 of the substrate 2. The hard mask 26a may be formed using plasma enhanced chemical vapour deposition PECVD of silicon dioxide, for example.

Windows are provided in the hard mask 26a so that back surface trenches 8a, 8b can be etched into the back surface of the substrate 2.

Depending on the desired aspect ratio of the trenches 8a, 8b, the method may start with a wafer that has been thinned or ground to a final thickness 16 of 400 µm, for example. Of course, grinding the wafer before initiating the method reduces the strength of the wafer and so makes it more fragile.

In figure 9, the back surface trenches 8a, 8b have been filled with an insulating material, which may be similar to the polymer layer 28 of the process in figures 2b to 7. An insulating layer 28 material is provided on the back surface. If the back surface 14 does not need to be thermally conductive for effective operation of the device 1e then the hard mask 26a and the insulating layer 28 may be retained in the final fabricated semiconductor device.

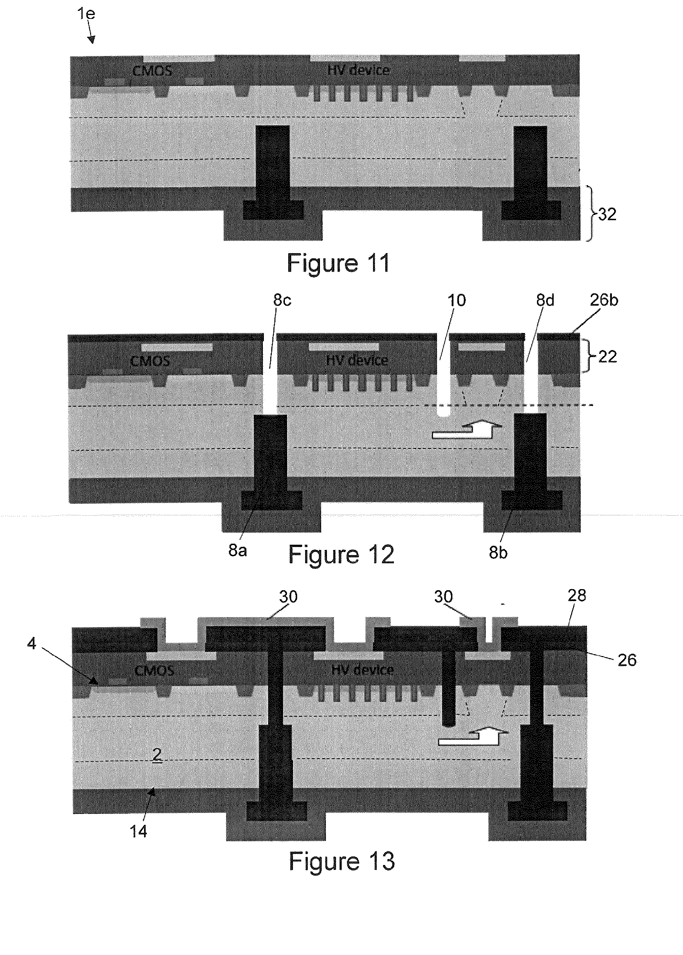

However, where the requirements of the device are such that good thermal conductivity is required at the back surface 14 then two alternative steps may be taken. The results of these alternative steps are shown in figures 10 and 11.

Figure 10 illustrates the semiconductor device 1 e after blanket etching or chemical mechanical polishing of the polymer layer 28 and hard mask 26a and deposition of a backside isolation layer (or stack) 32. The backside isolation layer 32 may be similar to that described with reference to figure 5.

Figure 11 illustrates the semiconductor device 1 e after opening windows in the polymer layer 28 and hard mask 26a with etching and/or exposure/developing (in case of photo sensitive polymers) of the polymer layer 28 followed by deposition of a backside isolation layer (or stack) 32.

The second option (shown in figure 11) may have advantages (compared to the process step in figure 10), such as providing a reduced leakage current along the bottom of the isolation trenches 8a, 8b. However, the second option also requires an extra photolithography step which must be aligned correctly with the back surface and so is more complicated than the first option.

Figure 12 shows the semiconductor device 1e of figure 11 after the deposition and structuring of a hard mask 26b on the interconnector layer 22. The hard mask 26b is similar to that described with reference to figure 2b.

Contact surface trenches 8c, 8d have been formed in windows defined by the hard mask 26b. When the front side trenches reach the depth of the polymer-filled backside trenches, the front side etch process can be stopped. In this way, the contact surface trenches 8c, 8d and back surface trenches 8a, 8b together form isolation trenches.

The contact surface trenches 8c, 8d can be narrower in comparison with the back surface trenches 8a, 8b because the contact surface trenches 8c, 8d can be shallower than the back surface trenches 8a, 8b. In this example, the contact surface trenches 8c, 8d are the same width and depth as the contact forming trench 10. Typically, the contact surface trenches 8c, 8d are formed in a single etching step.

The rest of the process (trench filling, polymer etch back, redistribution layer deposition and structuring) is comparable to the process steps in route 1 discussed with reference to figures 2b to 7. Possible final semiconductor devices are illustrated in figures 13 and 14.

Figure 13 illustrates a schematic cross-section of a final product semiconductor device after the hard mask 26b has been removed from the metal contacts 24 and an insulating polymer has been deposited in the contact surface trenches 8c, 8d and contact forming trench 10. The insulating polymer is also provided as a polymer layer 28 on the interconnector layer 22. A metal redistribution layer 30 is provided over the metal contacts 24 in a similar configuration to that described with reference to figure 4.

Figure 14 illustrates a schematic cross-section of a final product semiconductor device where the polymer layer 28 of figure 13 is removed before the metal redistribution layer 30 is formed.

Figure 15 illustrates a schematic cross-section of a final product semiconductor device where the back surface trenches 8a, 8b extend through the substrate 2 to form isolation trenches. The isolation trenches do not, therefore, need to pass through the interconnector layer 22 in this example. Connections between the drain of the CMOS device 20 and the vertical device 6 on the interconnector layer 22 may therefore be provided before the formation of the isolation trenches.

The interconnector layer 22 provided stability to the structure during the formation of the isolation trenches. Formation of the isolation trench comprises removing substrate material exclusively from the back surface 14, rather than the contact surface 4, in this example. The contact formation trench 10 is still, however, formed in the contact surface 4.

Figure 16 shows a semiconductor device 1f at various stages in an alternative fabrication process with many similarities to the process described with reference to figures 2b to 7.

Figure 16a illustrates the partially fabricated semiconductor device 1f similar to that described with reference to figure 2b. However, the semiconductor device 1f further comprises a hole filled with silicon dioxide, also referred to as a silicon dioxide plug 34. The silicon dioxide plug 34 replaces the N⁺⁺ sinker at the drain contact 12. The silicon dioxide plug 34 can be easily aligned because it is formed during fabrication of the contact side components (along with the CMOS 20 and vertical device 6).The oxide plug may also be smaller in dimension than a conventional through-silicon via which are typically formed at the end of the fabrication process.

The semiconductor device 1f illustrated in figure 16b is similar to that described with reference to figure 3. An insulating polymer has been deposited in the isolation trenches 8a, 8b and the contact forming trench 10. A layer 28 of the polymer material is provided on the hard mask 26 over the interconnector layer 22.

Figure 16c illustrates the semiconductor device 1f after the substrate 2 has been ground back so that the distance between the contact surface 4 and the back surface 14 is a final thickness 16 of the substrate 2. The isolation trench extends through the thickness 16 of the substrate 2.

Figure 16d illustrates the semiconductor device 1f after the metal contacts 24 have been uncovered (the hard mask 26 and polymer layer 28 material is locally removed) and an etch window has been formed on the back surface 14 between the first and second isolation trenches. That is, a hard mask 26c is provided over the substrate 2 except for the island occupied by the vertical device 6. Layer 26c protects the rest of the substrate 2 from etching while the island is etched.

Figure 16e illustrates the semiconductor device 1f after silicon has partly been etched away from the back surface of the vertical device 6 until the bottom of the silicon dioxide plug 34 and the contact forming trench 10 has been reached. The silicon substrate is locally etched with a relatively large area. This large area reduces the etch time significantly compared to the etching required to provide conventional through-silicon vias. The etching of through-silicon vias is very time consuming and therefore expensive.

Figure 16f illustrates the semiconductor device 1f after a wet oxide etching process to remove the silicon dioxide from the hole 34.

Figure 16g illustrates the semiconductor device 1f after seed layer deposition, structuring and an electroplated metal layer 36 have been formed on the contact surface and the back surface of the vertical transistor, as well in hole 34. A metal conduction path 18 is therefore provided within the substrate between the drain region and the drain contact 12. In comparison with a through-silicon via which goes through the full remaining substrate thickness, the resistance of this metal filled hole 34 can be significant lower because of its relative shallowness.The semiconductor device 1f can therefore exhibit an improved (reduced) on resistance because of the provision of an electrical conduction path.

A metal distribution mater 30 is also provided on the metal contacts 24 in a similar way to that described with reference to figure 4 or may be provided in a single step with front surface electroplating.

Figure 16h illustrates the semiconductor device 1f after an insulating layer of material, such as aluminium nitride, has been provided on the electroplated metal layer 36.

## Claims

1. A semiconductor device comprising:
a substrate having a contact surface and a back surface separated by a total distance;
a vertical device formed in the substrate and having first and second terminals on the contact surface;
an isolation trench extending the total distance through the substrate between the contact surface and the back surface to electrically isolate the vertical device; and
a terminal separation trench extending from the contact surface into the substrate and arranged to separate, and define an electrical conduction path between, the first and second terminals of the vertical device.

2. The semiconductor device of claim 1 comprising a second device on an opposing side of the isolation trench to the vertical device.

3. The semiconductor device of claim 2 wherein the isolation trench electrically isolates the vertical device from the second device.

4. The semiconductor device of any preceding claim wherein the isolation trench is continuous and form an island of substrate on which the vertical device is provided.

5. The semiconductor device of any preceding claim wherein the vertical device comprises a vertical transistor or vertical diode.

6. The semiconductor device of any preceding claim wherein an electrically insulating and thermally conductive material is provided on the back surface.

7. The semiconductor device of any preceding claim wherein the isolation trench and terminal separation trench each comprises a dielectric material.

8. The semiconductor device of any preceding claim wherein the electrical conduction path is at least partially defined by a metallic material provided within the substrate.

9. A method of fabricating a semiconductor device, comprising:
receiving a substrate having a contact surface with a vertical device formed in the substrate and having a first terminal on the contact surface;
forming an isolation trench extending a first distance through the substrate for electrically isolating the vertical device; and
forming a terminal separation trench extending from the contact surface into the substrate, the terminal separation trench arranged to define a second terminal of the vertical device on the contact surface and to define an electrical conduction path between first and second terminals.

10. The method of claim 9 wherein the isolation trench is a first isolation trench and the method comprises forming a second isolation trench on an opposing side of the vertical device to the first isolation trench, each of the first and second isolation trenches arranged to electrically isolate the transistor.

11. The method of claim 9 or 10 wherein the substrate has a back surface separated by a total distance from the contact surface.

12. The method of claim 11 wherein forming the isolation trench comprises removing substrate material from the back surface.

13. The method of claim 12 wherein forming the isolation trench comprises, subsequent to removing substrate material from the back surface, removing substrate material from the contact surface.

14. The method of claim 9 or 10 comprising reducing a thickness of the substrate from the initial thickness to a final product thickness to form a back surface opposing the contact surface.

15. The method of claim 9, 10 or 14 wherein the isolation trench and terminal separation trench are each formed during the same processing step.

## Amended claims

### Amended claims in accordance with Rule 137(2) EPC.

1. A semiconductor device comprising:
a substrate having a contact surface and a back surface separated by a total distance;
a vertical device formed in the substrate and having first and second terminals on the contact surface;
an isolation trench extending the total distance through the substrate between the contact surface and the back surface to electrically isolate the vertical device; and
a terminal separation trench extending from the contact surface into the substrate and arranged to separate, and define an electrical conduction path in the substrate between, the first and second terminals of the vertical device.

2. The semiconductor device of claim 1 comprising a second device on an opposing side of the isolation trench to the vertical device.

3. The semiconductor device of claim 2 wherein the isolation trench electrically isolates the vertical device from the second device.

4. The semiconductor device of any preceding claim wherein the isolation trench is continuous and form an island of substrate on which the vertical device is provided.

5. The semiconductor device of any preceding claim wherein the vertical device comprises a vertical transistor or vertical diode.

6. The semiconductor device of any preceding claim wherein an electrically insulating and thermally conductive material is provided on the back surface.

7. The semiconductor device of any preceding claim wherein the isolation trench and terminal separation trench each comprises a dielectric material.

8. The semiconductor device of any preceding claim wherein the electrical conduction path is at least partially defined by a metallic material provided within the substrate.

9. A method of fabricating a semiconductor device, comprising:
receiving a substrate having a contact surface with a vertical device formed in the substrate and having a first terminal on the contact surface;
forming an isolation trench extending a first distance through the substrate for electrically isolating the vertical device; and
forming a terminal separation trench extending from the contact surface into the substrate, the terminal separation trench arranged to define a second terminal of the vertical device on the contact surface and to define an electrical conduction path in the substrate between first and second terminals.

10. The method of claim 9 wherein the isolation trench is a first isolation trench and the method comprises forming a second isolation trench on an opposing side of the vertical device to the first isolation trench, each of the first and second isolation trenches arranged to electrically isolate the transistor.

11. The method of claim 9 or 10 wherein the substrate has a back surface separated by a total distance from the contact surface.

12. The method of claim 11 wherein forming the isolation trench comprises removing substrate material from the back surface.

13. The method of claim 12 wherein forming the isolation trench comprises, subsequent to removing substrate material from the back surface, removing substrate material from the contact surface.

14. The method of claim 9 or 10 comprising reducing a thickness of the substrate from the initial thickness to a final product thickness to form a back surface opposing the contact surface.

15. The method of claim 9, 10 or 14 wherein the isolation trench and terminal separation trench are each formed during the same processing step.
